# EUROPÄISCHE PATENTSCHRIFT

(11) **EP 0 642 728 B1**
(45) Veröffentlichungstag und Bekanntmachung des Hinweises auf die Patenterteilung: **26.03.1997**
(21) Anmeldenummer: 93909780.4
(22) Anmeldetag: 19.05.1993
(51) Int. Cl.: H05K 9/00

(54) **EINZELKONTAKTFEDER**
SINGLE CONTACT SPRING
RESSORT POUR CONTACT INDIVIDUEL

(30) Priorität: 26.05.1992 DE 4217436; 07.08.1992 DE 4226209
(43) Veröffentlichungstag der Anmeldung: 15.03.1995
(73) Patentinhaber: Siemens Nixdorf Informationssysteme Aktiengesellschaft, 33102 Paderborn (DE); J.N. EBERLE FEDERNFABRIK GmbH, D-86830 Schwabmünchen (DE)
(72) Erfinder: PATSCHECK, Max, D-24944 Flensburg (DE); SCHMALZL, Dieter, D-86153 Augsburg (DE); MENSCHING, Helmut, D-86356 Neusäss (DE)
(74) Vertreter: Fuchs, Franz-Josef, Dr.-Ing.
(86) Internationale Anmeldenummer: DE9300440
(87) Internationale Veröffentlichungsnummer: WO9325062

(56) Entgegenhaltungen:
- EP-A- 0 447 942
- DE-U- 9 112 299

## Beschreibung

Die Erfindung betrifft eine Einzelkontaktfeder, insbesondere für HF-Schirmung von elektronischen Geräten, zum Einrasten in Blechdurchbrüchen.

Elektrische Geräte müssen so abgeschirmt sein, daß hochfrequente Störstrahlungen weder aus dem Gerät heraus noch in das Gerät hinein kommen können. Solche Abschirmungen erfolgen beispielsweise für Fassaden von elektronischen Geräten, z.B. Türen, Seitenteilen und Dächern, aber auch für Trennwände, die zur Trennung zwischen geschirmten und ungeschirmten Räumen dienen und aus Blech mit metallischer Oberfläche versehen sind. Derartige Abschirmungen erfolgen meistens mit Federn, wobei diese durch komplizierte Bewegungsabläufe in Blechdurchbrüchen oder diversen Profilen so einrasten, daß formschlüssig ein Herausspringen bei mechanischen Beanspruchungen dauerhaft verhindert wird. Dabei ist häufig schwer in die Montagelochung zu finden. Es sind auch Federn bekannt, welche aus Kontaktstreifen auf die Kontaktoberfläche aufgeklebt werden. Diese Befestigung ist montagetechnisch problematisch und die Halteanforderungen werden nur schlecht erfüllt. Ferner sollten solche Federn so ausgelegt sein, daß sie Querkräften in Kontaktbereich bei mechanischen Beanspruchungen oder Montage standhalten. Weiterhin sind die Federwege bei bekannten Federsystemen kurz und lassen sich im kontaktierten Zustand nicht gegen Null bewegen. Sie können meistens auch nicht frei nach hinten wegfedern und weisen dadurch im Endzustand gegenüber dem Anfangskontakt hohe Federkräfte und Reibungsgeräusche auf. Derartige Kontaktelemente beanspruchen meist auch große Teilungsabstände.

Aus DE-U-91 12 299.6 ist eine Einzelkontaktfeder mit einem als Kontaktkalotte ausgebildeten Kontaktteil bekannt. Die Kontaktkalotte taucht bei einer Druckbeanspruchung nach unten weg. In ihrem unteren Teil ist sie zu ihrer Halterung mehrfach gebogen und zwar in der Weise, daß sie in ihrem Querschnitt trompetenförmig ausgebildet ist. Die Verbindung von Kontaktkalotte und dem unteren Teil der Einzelkontaktfeder ist in der Weise bewerkstelligt, daß die Kontaktkalotte als auslaufendes Teil des im Querschnitt trompetenhaft aussehenden Unterteils ausgebildet ist. Durch die mehrfache Biegung des Unterteils ist das Unterteil selbst federnd ausgebildet.

Aufgabe der vorliegenden Erfindung ist es, eine einzeln montierbare Kontaktfeder zu schaffen, die in einem Blechausschnitt leicht einrastet und nicht über ihre Elastizitätsgrenze hinaus verformt werden kann.

Zur Lösung dieser Aufgabe sieht die Erfindung gemäß Anspruch 1 oder Anspruch 7 daher eine Einzelkontaktfeder vor, die derart ausgebildet ist, daß sie aus einem Rastkäfig und einem als Kontaktkalotte ausgebildeten federnden Kontaktteil besteht, daß der Rastkäfig wannenförmig und in seinem unteren Teil im Querschnitt trapezförmig ausgebildet, an seinen beiden Stirnseiten offen und an seinen beiden Längsseiten mit zwei gegenüberliegenden Ausschnitten versehen ist, daß die Oberkanten der Längsseiten nach außen abgewinkelt sind, daß die Kon taktkalotte über ein an einer der Stirnseiten befestigtes, abgewinkeltes Trägerteil gehalten wird und daß in einem der Ausschnitte der Längsseiten ein nach außen gebogener Winkel angeordnet ist, in dem ein entsprechend entgegengesetzt gebogenes hakenförmiges mit der Kontaktkalotte verbundenes Teil eingreift.

Die Kontaktkalotte kann dabei entweder kegelförmig oder pyramidenförmig ausgebildet sein.

Durch diese Maßnahmen erhält man eine Feder, deren Montage durch Druck in Steckrichtung erfolgt und die leicht in die Montagelochung findet. Dadurch ist auch eine automatisierbare Montage möglich. Diese Feder wirkt durch Abfedern im Kontaktbereich Querkräften durch mechanische Einwirkung oder beim Bewegen bzw. Montieren der bestückten Teile entgegen und ist dadurch gegen Beschädigungen gesichert. Sie kann außerdem mit geringen Teilungsabständen montiert werden. Der Kontaktüberstand ist sehr groß und geht in kontaktiertem Zustand gegen Null. Die Feder kann nach hinten frei wegfedern, so daß sich die Bewegungskräfte mit zunehmendem Federweg über die form- und materialbedingte Federrate hinaus nicht unnötig erhöhen. Die Feder kann sowohl als Druckkontakt als auch als Schleifkontakt benutzt werden. Als Druckkontakt wird sie dabei an Schwenktüren benötigt, als Gleitkontakt bei Einschüben.

Soll die Feder nur beidseitig in Längsrichtung überfahrbar sein, so kann die Kontaktkalotte auch dachförmig ausgebildet werden.

Eine der beiden Dachschrägen kann sich in ein konvex gewölbtes federndes Trägerteil fortsetzen, das mit der, dieser Dachschräge gegenüberliegenden Stirnseite des Rastkäfigs und unter dessen Boden verlaufend, verbunden ist.

Zur Verhinderung einer bleibenden Verformung bzw. Abknickung des federnden Trägerteiles kann die Einzelkontaktfeder auch so ausgebildet sein, daß die Befestigung des Trägerteils an der gegenüberliegenden Stirnseite über eine schlaufenförmige Ausbildung des Trägerteils erfolgt.

Ein Teil des für die Realisierung der gegenüberliegenden Ausschnitte an den Längsseiten des Rastkäfigs zu entfernenden Materials kann als schräg nach außen gebogener Lappen stehen bleiben. Dadurch erhält man eine einfache Sicherung der Einzelkontaktfeder vor dem Herausfallen aus dem Rastloch.

Zur Erhöhung der Kontaktkräfte kann die Feder im Kontaktbereich der Kontaktkalotte eine warzenähnliche zusätzliche Prägung erhalten.

Um ein selbsttätiges Herausspringen der Feder aus dem Blechdurchbruch zu verhindern, können an den Ausschnitten der Längsseiten auch Rastnasen vorgesehen werden.

Anhand der Ausführungsbeispiele nach den Figuren 1 bis 5 wird die Erfindung näher erläutert. Es zeigen
Figur 1 eine Einzelkontaktfeder mit kegelförmiger Kontaktkalotte,
Figur 2 Einzelkontaktfedern nach Figur 1 in unterschiedlichem Einsatzzustand in den vorgesehenen Durchbrüchen und
Figur 3 eine Einzelkontaktfeder mit dachförmiger Kontaktkalotte,
Figur 4 eine weitere Einzelkontaktfeder von der Vorderseite,
Figur 5 die Einzelkontaktfeder nach Figur 4 von der Hinterseite des Rastkäfigs.

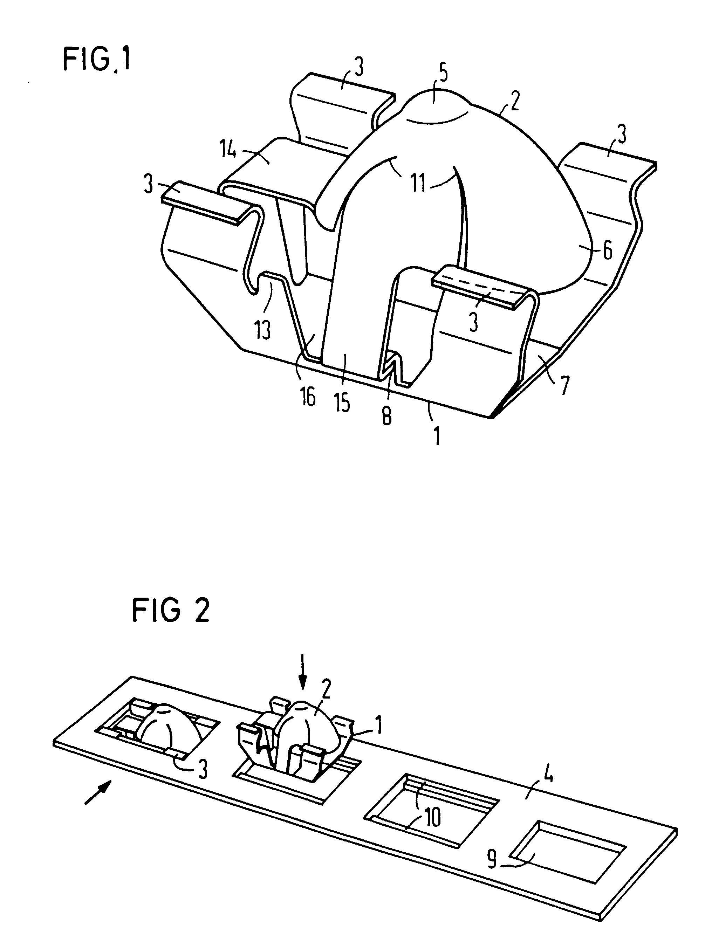

Die Einzelkontaktfeder nach Figur 1 besteht aus dem Rastkäfig 1, der wannenförmig und in seinem unteren Teil trapezförmig ausgebildet ist und dem Kontaktteil 2, das aus einer kegelförmigen Kontaktkalotte 6 besteht, die an ihrer oberen Kontaktzone mit einer zusätzlichen warzenförmigen Prägung 5 zur Erhöhung des Kontaktdrucks ausgebildet ist. Das kegelförmige Dach 11 ist außerdem über einen Winkel 14, der an der Stirnfläche des wannenförmigen Rastkäfigs angeordnet ist, gehalten, wobei ein weiteres abgewinkeltes Teil 15, das ebenfalls mit dem kegelförmigen Dach 11 der Kontaktkalotte verbunden ist, als Federwegbegrenzung dadurch dient, daß es mit seinem umgebogenen Teil in einen, in dem Ausschnitt 16 der Längsseite angeordneten, abgebogenen Winkel 8 eingreift. Die Längsseiten des Rastkäfigs sind an seiner Oberseite (Oberkanten 3) nach außen abgebogen und dienen so als Rastelemente in den Durchbrüchen 9, die in den Teilen 4, wie in Figur 2 gezeigt, in die die Einzelkontaktfedern eingerastet werden sollen, eingebracht sind.

Die Einzelkontaktfeder ist in die rechteckigen Blechdurchbrüche 9 in nur einer Bewegungsrichtung einschnappbar (Druck Knopf Lösung) und verankert und fixiert sich durch ihre Form. Außerdem findet sie leicht in die Montagelochungen 9 hinein. Die umgebogenen Ränder (Oberkanten) 3 der Längsseite des Rastkäfigs bilden dabei eine Uberdehnungsauflage. Die Feder ist zudem leicht austauschbar, weist einen großen Federweg auf und ist dabei nach hinten wenig in die Fassaden eingetaucht. Dadurch kann sie auch bei dünnen Fassaden verwendet werden. Die Feder taucht bei Beanspruchung frei nach hinten weg und erzeugt somit keine zusätzlichen Gegenkräfte. Die Kontaktkalotte 6 findet im Rastkäfig 1 eine Federwegbegrenzung 7 und kann dadurch nicht bleibend verformt werden. Die Federwegbegrenzung der Kontaktkalotte 6 nach oben bietet gleichzeitig eine Unabhängigkeit von der Blechstärke des Montageteils, indem immer der maximale Federweg verfügbar ist. Wesentlicher Vorteil dieser Feder ist ferner, daß sie zur Befestigung nur einen Durchbruch (Formloch) 9 benötigt, das bei den allgemeinen Lochungen der Blechteile fast ohne zusätzlichen Aufwand gefertigt werden kann. Wenn dieses Formloch umlaufend an der Fassade angebracht wird, kann die Fassade als Standardprodukt gefertigt werden und je nach Anforderung der eingebauten Elektronik mit mehr oder weniger Federn bestückt sein. Wenn das Formloch beim Stanzen im gleichen Arbeitsgang eine Prägung 10 erhält, kann die Schirmwirkung durch den geringen Abstand zwischen Fassade und Gerüst erhöht werden. Da die Feder völlig in die Prägung eintaucht, kann sie auf der Oberfläche seitlich überfahren werden.

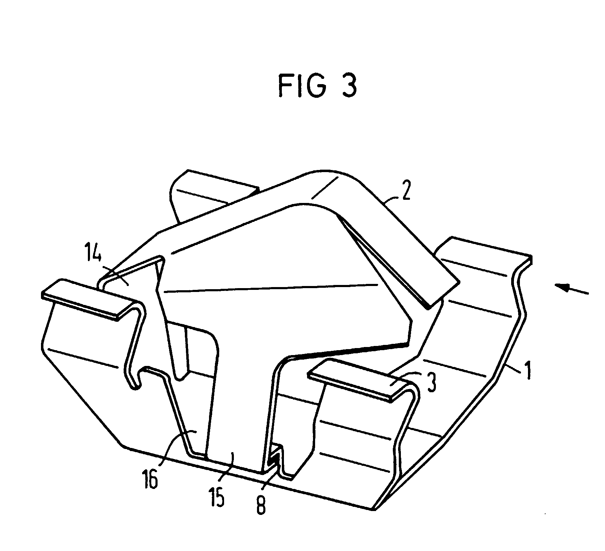

Der überstehende Kontaktteil der Feder, der als Kegelkalotte ausgebildet ist, nimmt dadurch Querkräfte auf, indem der Kontaktbereich der Feder auch bei seitlicher mechanischer Beanspruchung nach hinten wegfedert und an der gegenüberliegenden Blechfläche entlang gleitet, ohne sich zu verhaken. Dadurch ist die Feder besonders gut einsetzbar bei Einschubbaugruppen, die gegenüber Nachbarbaugruppen gut abgeschirmt werden müssen. Beim Einschieben der Baugruppen kann die Feder in jeder beliebigen Richtung überfahren werden (siehe Pfeile in den Figuren 2 und 3).

Wenn der überstehende Kontaktteil der Kontaktkalotte der Feder, wie in Figur 3 dargestellt, dachförmig ausgeführt wird, ist diese Feder nur in Längsrichtung beidseitig überfahrbar. Die Richtung der Überfahrbarkeit der Feder kann bei quadratischer Ausbildung von Feder- und Blechdurchbruch bei der Montage auch um 90° gedreht werden. Der Vorteil dieser dachförmigen Kalottenausführung ist eine durch flächige Kontaktanlage verbesserte HF-Schirmung.

Gegen ein ungewolltes Ausrasten der Feder wirken zwei seitlich im Rastkäfig befindliche Rastnasen 13, die sich gegen die Rückseite des Bleches, in dem sich die Durchbrüche 9 befinden, abstützt. Ohne die Möglichkeit einer seitlichen Überfahrung der Feder, kann diese auch einfacher ausgeführt werden.

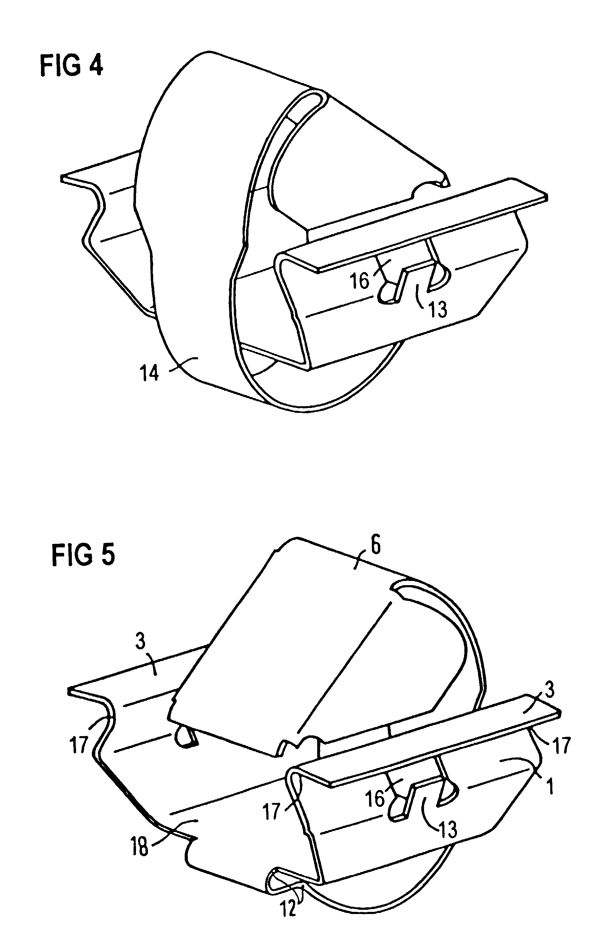

Eine weitere Einzelkontaktfeder mit dachförmig ausgebildeter Kalotte ist in den Figuren 4 und 5 dargestellt. Das Trägerteil 14 ist als Fortsetzung der einen Dachschräge der dachförmig ausgebildeten Kalotte 6 in einem langen Bogen unter dem Rastkäfigboden 18 durchgeführt und mit dem Boden an der gegenüberliegenden Stirnseite des Rastkäfigs 1 verbunden. Diese Bogenführung läßt eine feinere Federrastabstimmung und geringere Kontaktkräfte zu und wirkt einer bleibenden Verformung des Federmaterials entgegen. Eine bleibende Verformung bzw. das Abknicken des federnden Trägerteils 14 an der Befestigungsstelle wird durch eine schlaufenförmige Ausbildung 12, an der Verbindungsstelle zwischen Rastkäfig 1 und Trägerteil 14 verhindert. Diese Ausformung trägt auch zur Richtungsstabilisierung des Trägerteils 14 bei.

Die Feder ist in zwei Richtungen seitlich überfahrbar, durch Ein- bzw. Aufrollen des Federträgers und kann zusätzlich von oben kontaktiert werden.

Mit dieser Konstruktion ist auch eine quadratische Rastlochausbildung möglich, so daß dadurch die Überfahrrichtung bei der Einzelfedermontage bestimmt wird. Der Kontaktbereich der Kalotte 6 ist linear bzw. leicht flächig ausgeführt und entspricht damit den HF-Anforderungen besonders gut.

Der Rastkäfig 1 ist im Bereich der beiden nach außen gebogenen Längsseiten, die als Auflagen im Rastloch dienen, nicht unterbrochen und dadurch einfach und stabil ausführbar. Diese stabile Rastkäfigausführung ermöglicht ein Einpressen (Preßsitz) der Einzelkontaktfeder in einen lackierten Durchbruch, bei gleichzeitigem Auftrennen der Lackschicht im Randbereich 17 der nach außen gebogenen Längsseiten. Dadurch ist eine Kontaktierung lackierter Teile möglich.

Gegenüber den Ausführungsbeispielen nach den Figuren 1 bis 3 tritt eine weitere Verbesserung der Schirmwirkung durch Linien- bzw. Flächenauflage im Kontaktbereich zum Gegenblech auf, außerdem eine Verbesserung der Federeigenschaften, um einer bleibenden Verformung bei hohem Kalottenüberstand entgegenzuwirken und die Kontaktkräfte in Grenzen zu halten. Der Rastkäfig ist bezüglich der Stabilität verbessert und die zusätzlichen Anforderungen, bei lackierten Flächen die Lackschicht aufzutrennen und metallisch zu kontaktieren, in einfacher Weise gewährleistet.

## Patentansprüche

1. Einzelkontaktfeder, insbesondere für HF-Schirmung von elektronischen Geräten, zum Einrasten in Blechdurchbrüchen,
**dadurch gekennzeichnet,** daß sie aus einem Rastkäfig (1) und einem als Kontaktkalotte (6) ausgebildeten federnden Kontaktteil (2) besteht, daß der Rastkäfig (1) wannenförmig und in seinem unteren Teil im Querschnitt trapezförmig ausgebildet, an seinen beiden Stirnseiten offen und an seinen beiden Längsseiten mit zwei gegenüberliegenden Ausschnitten (16) versehen ist, daß die Oberkanten (3) der Längsseiten nach außen abgewinkelt sind, daß die Kontaktkalotte (6) über ein an einer der Stirnseiten befestigtes, abgewinkeltes Trägerteil (14) gehalten wird und daß in einem der Ausschnitte (16) der Längsseiten ein nach außen abgebogener Winkel (8) angeordnet ist, in dem ein entsprechend entgegengesetzt gebogenes hakenförmiges, mit dem Kontaktteil (6) verbundenes Teil (15) eingreift.

2. Einzelkontaktfeder nach Anspruch 1, **dadurch gekennzeichnet,** daß die Kontaktkalotte (6) kegelförmig ausgebildet ist.

3. Einzelkontaktfeder nach Anspruch 1, **dadurch gekennzeichnet,** daß die Kontaktkalotte (6) pyramidenförmig ausgebildet ist.

4. Einzelkontaktfeder nach einem der Ansprüche 2 oder 3, **dadurch gekennzeichnet,** daß die Kontaktkalotte (6) im Kontaktbereich eine zusätzliche warzenförmige Prägung (5) aufweist.

5. Einzelkontaktfeder nach Anspruch 1, **dadurch gekennzeichnet,** daß die Kontaktkalotte (6) dachförmig ausgebildet ist.

6. Einzelkontaktfeder nach einem der Ansprüche 1 bis 5, **dadurch gekennzeichnet,** daß die Ausschnitte (16) mit Rastnasen (13) versehen sind.

7. Einzelkontaktfeder, insbesondere für HF-Schirmung von elektronischen Geräten, zum Einrasten in Blechdurchbrüchen, **dadurch gekennzeichnet,** daß sie aus einem Rastkäfig (1) und einer wenigstens zwei Dachschrägen aufweisenden dachförmigen Kontaktkalotte (6) besteht, daß der Rastkäfig (1) wannenförmig und in seinem unteren Teil im Querschnitt trapezförmig ausgebildet, an seinen beiden Stirnseiten offen und an seinen beiden Längsseiten mit zwei gegenüberliegenden Ausschnitten (16) versehen ist, daß die Oberkanten (3) der Längsseiten nach außen abgewinkelt sind, und daß eine der Dachschrägen sich in ein konvex gewölbtes federndes Trägerteil (14) fortsetzt, das unter dem Boden (18) des Rastkäfigs (1) durchgeführt, und das mit der dieser Dachschräge gegenüberliegenden Stirnseite des Rastkäfigs (1) und unter dessen Boden (18) verlaufend verbunden ist.

8. Einzelkontaktfeder nach Anspruch 7, **dadurch gekennzeichnet,** daß die Ausschnitte (16) mit Rastnasen (13) versehen sind.

9. Einzelkontaktfeder nach Anspruch 7 oder 8, **dadurch gekennzeichnet,** daß das Trägerteil (14) schlaufenförmig ausgebildet ist.

## Claims

1. Single contact spring, especially for RF-screening of electronic devices, for latch-locking into sheet-metal apertures, characterized in that it comprises a latch cage (1) and a resilient contact part (2) configured as a contact cup (6), in that the latch cage (1) is configured in a trough shape and, in its lower part, trapezoidally in cross-section, is open at its two front ends and is provided on its two longitudinal sides with two cutouts (16) located one opposite the other, in that the top edges (3) of the longitudinal sides are angled-off outward, in that the contact cup (6) is held by means of an angled-off carrier part (14) fastened to one of the front ends and in that in one of the cutouts (16) in the longitudinal sides there is disposed an outwardly bent-off elbow (8) in which there engages a correspondingly opposite-bent, hook-shaped part (15), which is connected to the contact part (6).

2. Single contact spring according to Claim 1, characterized in that the contact cup (6) is conically configured.

3. Single contact spring according to Claim 1, characterized in that the contact cup (6) is pyramidally configured.

4. Single contact spring according to one of Claims 2 or 3, characterized in that the contact cup (6) exhibits in the contact region an additional nipple-shaped embossment (5).

5. Single contact spring according to Claim 1, characterized in that the contact cup (6) is configured in a roof shape.

6. Single contact spring according to one of Claims 1 to 5, characterized in that the cutouts (16) are provided with latch bosses (13).

7. Single contact spring, especially for RF-screening of electronic devices, for latch-locking into sheet-metal apertures, characterized in that it comprises a latch cage (1) and a roof-shaped contact cup (6) having at least two roof slopes, in that the latch cage (1) is configured in a trough shape and, in its lower part, trapezoidally in cross-section, is open at its two front ends and is provided on its two longitudinal sides with two cutouts (16) located one opposite the other, in that the top edges (3) of the longitudinal sides are angled-off outward, and in that one of the roof slopes continues into a convexly curved, resilient carrier part (14), which is led through below the base (18) of the latch cage (1) and which is connected to that front end of the latch cage (1) lying opposite this roof slope, whilst running under the base (18) of the said latch cage.

8. Single contact spring according to Claim 7, characterized in that the cutouts (16) are provided with latch bosses (13).

9. Single contact spring according to Claim 7 or 8, characterized in that the carrier part (14) is configured in a loop shape.

## Revendications

1. Ressort de contact individuel, en particulier pour le blindage H.F. d'appareils électroniques, destiné à s'encliqueter dans des découpures de tôle, caractérisé en ce qu'il est composé d'une cage encliquetable (1) et d'un élément de contact (2) élastique réalisé sous forme de calotte de contact (6), en ce que la cage encliquetable (1) est réalisée en forme de cuvette avec une partie basse de section trapézoïdale, deux faces frontales ouvertes et deux côtés longitudinaux pourvus de découpures (16) se faisant face, en ce que les bords supérieurs (3) des côtés longitudinaux sont coudés vers l'extérieur, en ce que la calotte de contact (6) est tenue par un support (14) coudé fixé à l'une des faces frontales et en ce qu'une équerre (8) courbée vers l'extérieur est disposée dans l'une des découpures (16) des côtés longitudinaux, dans laquelle s'enclenche un élément (15) courbé en sens inverse en forme de crochet qui est relié à l'élément de contact (6).

2. Ressort de contact individuel selon la revendication 1, caractérisé en ce que la calotte de contact (6) est réalisée en forme de cône.

3. Ressort de contact individuel selon la revendication 1, caractérisé en ce que la calotte de contact (6) est réalisée en forme de pyramide.

4. Ressort de contact individuel selon l'une des revendications 2 ou 3, caractérisé en ce que la calotte de contact (6) présente dans la zone de contact en outre une empreinte (5) en forme de bouton.

5. Ressort de contact individuel selon la revendication 1, caractérisé en ce que la calotte de contact (6) est réalisée en forme de toit.

6. Ressort de contact individuel selon l'une des revendications 1 à 5, caractérisé en ce que les découpures (16) sont pourvues de taquets encliquetables (13).

7. Ressort de contact individuel, en particulier pour le blindage H.F. d'appareils électroniques, destiné à s'encliqueter dans des découpures de tôle, caractérisé en ce qu'il est composé d'une cage encliquetable (1) et d'une calotte de contact (6) en forme de toit comportant au moins deux pentes de toit, en ce que la cage encliquetable (1) est réalisée en forme de cuvette avec une partie basse de section trapézoïdale, deux faces frontales ouvertes et deux cotés longitudinaux pourvus de découpures (16) se faisant face, en ce que les bords supérieurs (3) des côtés longitudinaux sont coudés vers l'extérieur et en ce que l'une des pentes de toit se prolonge en un support (14) élastique bombé de manière convexe qui passe sous le fond (18) de la cage encliquetable (1) et qui est relié à la face frontale opposée à cette pente de toit de la cage encliquetable (1) en passant sous le fond (18) de celle-ci.

8. Ressort de contact individuel selon la revendication 7, caractérisé en ce que les découpures (16) sont pourvues de taquets encliquetables (13).

9. Ressort de contact individuel selon la revendication 7 ou 8, caractérisé en ce que le support (14) est réalisé en forme de boucle.
